# EUROPÄISCHE PATENTSCHRIFT

(11) **EP 0 818 024 B1**
(45) Veröffentlichungstag und Bekanntmachung des Hinweises auf die Patenterteilung: **27.01.1999**
(21) Anmeldenummer: 96905735.5
(22) Anmeldetag: 15.03.1996
(51) Int. Cl.: G06K 19/077

(54) **KARTENFÖRMIGER DATENTRÄGER**
CARD-LIKE DATA SUBSTRATE
SUPPORT DE DONNEES SOUS FORME DE CARTE

(30) Priorität: 31.03.1995 DE 19512191
(43) Veröffentlichungstag der Anmeldung: 14.01.1998
(73) Patentinhaber: SIEMENS AKTIENGESELLSCHAFT, 80333 München (DE)
(72) Erfinder: HOUDEAU, Detlef, D-93047 Regensburg (DE); KIRSCHBAUER, Josef, D-93476 Blaibach (DE); FILSER, Christoph, D-86825 Bad Wörishofen (DE)
(86) Internationale Anmeldenummer: DE9600464
(87) Internationale Veröffentlichungsnummer: WO9630867

(56) Entgegenhaltungen:
- EP-A- 0 254 640
- EP-A- 0 599 194
- WO-A-92/13318
- DE-C- 4 441 931
- US-A- 4 578 573
- PATENT ABSTRACTS OF JAPAN vol. 11, no. 319 (P-627) [2766] , 17.Oktober 1987 & JP,A,62 107391 (NIPPON TEXAS INSTR.), 18.Mai 1987,

## Beschreibung

Die Erfindung betrifft einen kartenförmigen Datenträger, der im wesentlichen aus Kunststoff besteht, mit mindestens einem Halbleiterspeicherelement und mit galvanischen Kontakten, worin die elektrischen Leiterbahnen auf dem Datenträger zur Verbindung des oder der Halbleiterspeicherelemente mit den galvanischen Kontakten durch ein einziges Leadframe dargestellt werden, an dem zumindest Teile der galvanischen Kontakte integral ausgebildet sind

Ein solcher Datenträger ist aus der EP 0 254 640 Al bekannt. Auch die JP-A-62 107391 zeigt einen solchen Datenträger bei dem ein Halbleiterchip auf einem Leadframe montiert und derart von Kunststoff umgeben ist, daß Teile des Leadframe als galvanische Kontakte nach außen führen.

Andere bekannte und im Einsatz befindliche Datenträgersysteme sind zum Beispiel Magnetbänder, die in der Regel aus Polyester bestehen, die mit einem Magnetpulver bzw. einer magnetisierbaren Schicht bedeckt sind. Hierbei ist eine Vielzahl von Ausführungen zu nennen wie Bänder (Tapes), Kassetten, Cartidges oder auch die Smart Card, die beispielsweise aus PVC (Polyvinylchlorid) besteht und eine eingeprägte Struktur oder einen Magnetstreifen aufweisen kann. Weiterhin sind optische Systeme bekannt wie die CD (Compact Disc; CD-ROM/Compact Disc; Nur-Lese-Speicher). Die einzelnen Ausführungen können entweder nur auslesbar oder auslesbar und auch wiederbeschreibbar sein.

Die neuartigsten Datenträgersysteme enthalten einen oder mehrere Halbleiterspeicherelemente. Hierzu eignen sich, insbesondere auch aus Kostengründen, kommerzielle Schreib- und Lesespeicher. Diese können beispielsweise als DRAM (Dynamischer Schreib/Lesespeicher) ausgeführt sein. Als ein Datenträgersystem, insbesondere als Datenträgerkarte, ist heute die Smart

Card am weitesten verbreitet. Daneben sind Datenträger für Datenverarbeitungssysteme bekannt (PCMCIA-Standard), die beispielsweise an einem Personalcomputer als externe Datenträger unterstützend eingesetzt werden können. Diese enthalten eine Vielzahl von Halbleiterelementen und können beispielsweise auch als Ersatz für eine Festplatte dienen.

Bei der sog. Smart Card in einer Version als Chipkarte und bei einer Memory Card ist in der Regel die kontaktbehaftete Datenübertragung unter Einsatz von galvanischen Kontakten ausgeführt. Dies stellt prinzipiell einen wesentlichen Unterschied zu einem elektronischen Standardbauelement dar. Ein DIL (Dual In Line)-Gehäuse eines Halbleiterchips weist völlig andere Kontaktiermittel nach außen hin auf, als eine der erwähnten Karten. Bei einem kartenförmigen Datenträger der oben erwähnten Art werden in der Regel Steckkontakte benutzt, die je nach Ausführungsform und je nach Anforderung besonders ausgestaltet werden. Zunächst sind die Halbleiterspeicherelemente in die Kunststoffkarten zu integrieren, wobei diese Karten in ihren Abmessungen nicht unbedingt einer Norm von Chipkarten entsprechen müssen, dies jedoch sinnvollerweise der Fall ist. Wesentlich ist, daß die geforderte Speicherkapazität der Halbleiterelemente in einer Datenträgerkarte verbunden ist mit einem wesentlichen Platzbedarf für solche Halbleiterspeicherchips. Die Datenträgersysteme in Form einer Datenträgerkarte besitzen wie gesagt sog. Steck- und Ziehkontakte und müssen entsprechend Kräfte übertragen,damit die Karte mit den entsprechenden Kontakten an einem Datenverarbeitungssystem bzw. an einem Adapter eingesteckt bzw. herausgezogen werden kann. Nachdem die relativ großen Hauptflächen einer solchen Datenträgerkarte zur im wesentlichen werbemäßigen Informationsvermittlung dienen sollen, wäre es wichtig, die galvanischen Kontakte in sich stabil auszubilden, um nicht durch eine Kraftübertragung auf den Kunststoffkörper des Datenträgers eine Beschädigung der Werbeflächen zu verursachen. Dies ist auch vor dem Hintergrund zu sehen, daß eine solche Karte im Gebrauch eine sehr hohe Anzahl von Ein- bzw. Aussteckvorgängen nach Möglichkeit beschädigungsfrei überstehen soll.

Als besondere Ausführungen für galvanische Kontaktverbindungen wären an dieser Stelle beispielsweise Steck- und Ziehkontakte zu nennen oder Schnappverbindungen, Messerleisten bzw. Klemmleisten oder ähnliches.

Es ist erkennbar, daß die elektrische Verbindung eines Halbleiterbausteines nach außen hin auf jeden Fall über eine lösbare elektrische Verbindung geschieht. Der Standardmontageprozeß eines Halbleiterbausteines in Verbindung mit einem Leadframe sieht im Gegensatz dazu eine nichtlösbare elektrische und mechanische Verbindung der äußeren Anschlußbeinchen (Outerleads) vor. Die Montagetechnik bei einer Chipkarte ist insofern nicht auf einen Datenträger der oben beschriebenen Art übertragbar, als das in eine Chipkarte eingesetzte Modul im Verhältnis zur Größe der Datenträgerkarte sehr klein ist.

Der Erfindung liegt die Aufgabe zugrunde, einen kartenförmigen Datenträger zur Verfügung zu stellen, der ein oder mehrere Halbleiterspeicherelemente mit einem wesentlichen Platzbedarf innerhalb der Karte aufweist, zur Datenübertragung nach außen mit galvanischen Kontakten versehen ist und der im Betrieb insgesamt eine hohe Stabilität, bezogen auf den Kunststoffkörper und die Kontakte, aufweist.

Die Lösung dieser Aufgabe geschieht durch die Merkmale des Anspruches 1.

Der Erfindung liegt die Erkenntnis zugrunde, daß besondere Vorteile mit einem Leadframe verbunden sind, das integral bzw. einstückig ausgebildet ist mit den galvanischen Kontakten bzw. mit Teilen davon. Dies bedeutet, daß das Leadframe einerseits zur elektrischen Kontaktierung und mechanischen Halterung des oder der Halbleiterspeicherelemente dient und andererseits zur Ausbildung der galvanischen Kontakte. Zu diesem Zweck kann kein herkömmliches Leadframematerial eingesetzt werden. Um die Anforderungen einerseits in Richtung Halbleiterspeicherelemente und andererseits in Richtung galvanische Kontakte zu erfüllen, muß bei dem verwendeten Werkstoff ein Kompromiß getroffen werden.

In vorteilhafter Weise wird ein Sonderfederwerkstoff eingesetzt, der solche Werkstoffkennwerte aufweist, daß er gleichzeitig Anforderungen an die die Chipkontaktierung, sowie auch die Anforderungen an die galvanischen Kontakte erfüllt. Bezüglich der Anforderungen ist insbesondere zu nennen, daß der Temperaturkoeffizient des E-Modules (Temperaturabhängigkeit, auch als Temperaturgang bezeichnet), sehr gering ist. Gleichzeitig soll der thermische Ausdehnungskoeffizient ebenfalls gering sein, damit eine gute Anpassung des metallischen Leadframes, das Halbleiterelemente trägt, zum Material eines Halbleiterelementes gewährleistet ist. Weiterhin ist eine hohe oder sehr hohe Federbiegegrenze gewünscht. Diese soll auch bei höheren Temperaturen nicht wesentlich absinken.

Ein Sonderfederwerkstoff mit den genannten Anforderungen erfüllt somit einerseits die Anfordereungen, die an elektrische Leiterbahnen und an die Leadframes gestellt werden, in Verbindung mit den Anforderungen, die an beispielsweise federnde galvanische Kontakte gestellt werden. Dabei sind insgesamt zu betrachten die Chipfixierung, die Chippositionierung auf einer Insel eines Leadframes, die elektrische Stromführung, sowie die Kontaktierung nach außen hin und die federnden Eigenschaften von Kontakten, wie sie aus der Feinwerktechnik gewünscht sind. Somit ist der bzw. sind die elektrischen Leiter integral oder einstückig ausgebildet mit den Kontakten eines kartenförmigen Datenträgers nach außen hin.

Als besondere Materialauswahl sind die Legierungen KupferZinn-6 bzw. Kupfer-Zinn-8 (CuSn6, CuSn8) zu nennen. Dies sind besonders günstige kombinierte Leadframematerialien mit Federeigenschaften. Wünschenswert ist in diesem Zusammenhang beispielsweise eine Streckgrenze von über 1000 N/mm². Dieser Wert kann beispielsweise von Eisennickellegierungen erreicht werden. Um die Korrosionsanfälligkeit von Eisenlegierungen herabzusetzen, werden Chromanteile zulegiert. So ist beispielsweise der Einsatz einer Legierung wie Eisen/Nickel/42/Chrom/5 (FeNi42Cr5) vorteilhaft. Diese Legierung erfüllt die obengenannten Anforderungen und weist ebenfalls einen Korrosionsschutz auf, so daß ein Überzug des Leadframes mit einer Edelmetallschicht entfallen kann. Durch den Chromanteil tritt eine Selbstpassivierung ein. Durch weitere metallurgische oder metallografische Einstellungen, wie beispielsweise hohe Reinheit des Materiales oder kleine Korngröße, lassen sich zum Beispiel die elektrische Leitfähigkeit positiv beeinflussen.

Der bisherige Einsatz von Leadframes bei der Herstellung von kunststoffumkapselten elektronischen Bauelementen sieht die mechanische Halterung der elektronischen Bauelemente auf einer Insel des Leadfremes vor, wobei auch die elektrische Kontaktierung zwischen den elektronischen Bauelementen und den inneren Anschlußbeinchen eines Leadframes vorgenommen wird. Hierzu sind keine Federwerkstoffeigenschaften notwendig. Somit war der Werkstoff des Leadframes darauf zu optimieren, bestmöglichst an die Werkstoffeigenschaften des Halbleiterbauelementes angepaßt zu sein. Ein Leadframe zur Verwendung in einem kartenförmigen Datentrager, das neben den erwähnten Eigenschaften auch Federwerkstoffeigenschaften aufweisen soll, kann in vorteilhafter Weise eine insgesamt stützende bzw. stabilisierende Eigenschaft in eine kartenförmige Datenträgeranordnung einbringen. Dies ist insbesondere bei der Herstellung von kartenförmigen Datenträgern wichtig, da hierfür zunehmend Spritzgießverfahren unter Verwendung von Thermoplasten bzw. thermoplastischen Kunststoffen verwendet werden. Somit liegt in Form des erfindungsgemäßen Leadframes zunächst eine stabile Einheit mit darauf montierten und elektrisch verbundenen Halbleiterspeicherelementen vor, die zumindest Teile der galvanischen Außenkontakte aufweist. Diese Einheit kann äußerst vorteilhaft in Bandform einem Spritzverfahren zur Herstellung von kartenförmigen Datenträgern zugeführt werden, wobei Teile des Leadframes für eine Positionierung beispielsweise innerhalb einer Kavität vorgesehen sind. Nach einer derartigen Umspritzung mit einem Thermoplasten ist von den Halbleiterspeicherelementn und dem Leadframe nach außen lediglich die Leiste bzw. Reihe von galvanischen Kontakten zu sehen. Zur weiteren Erhöhung der Stabilität des Leadframes für ein Herstellungsverfahren können beisielsweise stabilisierende Formgebungen am Leadframe eingesetzt werden (Falzen oder ähnliches).

Im folgenden wird anhand der schematischen Figur ein Ausführungsbeispiel beschrieben.

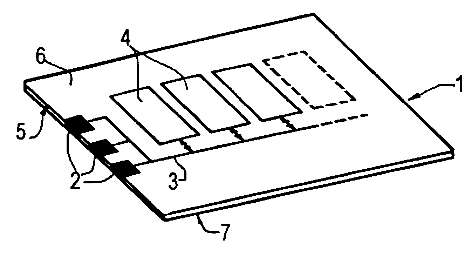

Die Figur zeigt schematisch einen kartenförmigen Datenträger 1 mit darauf bzw. darin befindlichen Speicherchips 4. Der Datenträger 1 ist ein- oder mehrlagig aus einem thermoplastischen Kunststoff hergestellt und weist umlaufende Seitenflächen 5 auf, sowie zwei Hauptflächen 6,7. Kontakte 2 für die Datenübertragung von oder auf den Datenträger 1 sind in diesem Beispiel am Rand, also im Bereich einer Seitenfläche 5 angeordnet. Wie in der Figur dargestellt, ist die Anordnung der Kontakte 2 an einer Schmalseite des Datenträgers 1 vorgesehen. Prinzipiell kann diese Kontaktanordnung auch an einer anderen Stelle des Datenträgerrandes geschehen. Es muß jedoch eine für die Art des Datenträgers einheitliche Anzahl und Positionierung von Kontakten 2 vorliegen, so daß eine erforderliche Vereinheitlichung für den täglichen Gebrauch mit entsprechenden Datenlesesystemen gegeben ist.

Auf dem Datenträger 1 ist mindestens ein Speicherchip 4, d.h. mindestens ein Halbleiterspeicherelement vorhanden, das über einen Bus 3 bzw. über eine Busleitung oder über ein Bussystem (Adressbus, Steuerbus, Datenbus), je nach Anforderung an die Datenübertragungsrate, mit Kontakten 2 verbunden ist. Aus Kostengründen wird auf die gängigen Typen von Halbleiterspeicherelementen zurückgegriffen. Dabei kann die Speicherkapazität des Datenträgers 1 durch Mehrfachanordnung von Speicherchips 4 entsprechend stufenweise erhöht werden. Die in der Figur dargestellten drei Speicherchips 4, die jeder für sich an den Bus 3 angeschlossen sind, können je nach Platzreserve auf dem Datenträger 1 in ihrer Anzahl variiert bzw. maximiert werden. Entsprechend können verschiedene Datenträger 1 mit unterschiedlicher Speicherkapazität und entsprechend unterschiedlichem Preis angeboten werden.
Die minimale Speicherkapazität eines Datenträgers 1 liegt bei mindestens 1 Mbit. Ein solcher Datenträger hätte ausreichende Speicherkapazität zur Speicherung von Daten für beispielsweise ein Musikstück. Dabei beinhaltet der Datenträger 1 im wesentlichen nur Halbleiterspeicherelemente.

Bei den bisher bekannten Chipkarten (Smart Card) stand das Identifizierungssystem im Vordergrund. Dabei wird der Zugriff auf einen darin befindlichen Speicher durch eine Sicherheitslogik kontrolliert. Diese ist im einfachsten Fall ein Schreib- oder Löschschutz für den Speicher oder für einzelne Bereiche desselben. Darüber hinaus gibt es Speicherchips mit einer komplexen Sicherheitslogik. Die Funktionalität der Chipkarten ist meist auf eine spezielle Anwendung hin optimiert. Typische Anwendungen in dieser Hinsicht sind beispielsweise Telefonkarte oder Krankenversicherungskarte. Neben den beschriebenen Speicherkarten in der Familie der Chipkarten sind sog. Mikroprozessorkarten bekannt. Diese enthalten in der Regel mindestens ein Programm (Betriebssystem) und verarbeiten oder bearbeiten Daten in einer bestimmten vorgeschriebenen Art und Weise. Beiden, den Speicherkarten und den Mikroprozessorkarten, ist jedoch gemeinsam, daß entweder ein Identifizierungssystem für den Zugang zu den gespeicherten Daten oder eine im Vordergrund stehende Prozessorcharakteristik impliziert ist.

Ein kartenförmiger Datenträger 1 entsprechend der Erfindung weist fast ausschließlich Halbleiterspeicherelemente auf. Logikeinheiten für die allgemeine Verwaltung der gespeicherten Daten sind weitestgehend in ein Datenverarbeitungs- bzw. Datenlesesystem verlagert und befinden sich nicht auf dem Datenträger 1. Der Datenträger 1 wird über die Kontakte 2 an ein solches Datenverarbeitungssystem angeschlossen. Dabei besteht die Möglichkeit, daß wiederum zur Erweiterung der Speicherkapazität mehrere Datenträger 1 stapelbar sind und als Stapel bzw. nacheinander an das Datenverarbeitungssystem angeschlossen werden können.
Die Speicherchips 4 befinden sich im Inneren des Datenträgers 1. Somit sind die zwei Hauptflächen 6,7 des kartenförmigen Datenträgers 1 als Werbeflächen nutzbar. Nachdem die Datenträger in Stückzahlen von Hunderten Millionen im Umlauf sein können, werden ihre Oberflächen intensiv als Werbeflächen oder als Flächen für Identifizierungsaufdrucke benutzt.

Einerseits wäre aus Kompatibilitätsgründen die Übernahme der lateralen Abmessungen der Smart Card (ISO 7812/7816; International Organization for Standardization) sinnvoll. Andererseits besteht für einen kartenförmigen Datenträger entsprechend der Erfindung keine Notwendigkeit, die äußeren Ausmaße an eine bestehende Norm anzupassen. Die Stärke des kartenförmigen Datenträgers 1 ist jedenfalls größer als die der Smart Card. Dies ist zurückzuführen auf die Bauhöhe der Speicherchips 4. Um die Gesamtstarke bzw. Höhe des Datenträgers 1 abzuschätzen, müssen weitere Höhenanteile für die mechanische und elektrische Verbindung der Speicherchips 4 sowie für entsprechende Kunststofflagen des Trägerkörpers einkalkuliert werden. Die Gesamtstarke des Datenträgers 1 kann beispielsweise 2 oder 3 mm betragen. Durch die flächige Ausbildung der Speicherchips 4 kann keine Flexibilität, ähnlich der der Smart Card, gewährleistet werden.

Weitere Einsatzfalle für einen kartenförmigen Datenträger 1 wären beispielsweise Anwendungen für tragbare Computer, Video- oder andere Bilddarstellungsverfahren.

## Patentansprüche

1. Kartenförmiger Datenträger, der im wesentlichen aus Kunststoff besteht, mit mindestens einem Halbleiterspeicherelement (4) mit einer Speicherkapazität von mindestens einem Mbit und mit galvanischen Kontakten (2) zur Übertragung von Daten zwischen einem Datenverarbeitungssystem und den Halbleiterspeicherelementen des Datenträgers, worin die elektrischen Leiterbahnen (3) auf dem Datenträger zur Verbindung von den Halbleiterspeicherelementen mit den galvanischen Kontakten durch ein einziges Leadframe dargestellt werden, an dem zumindest Teile der galvanischen Kontakte integral ausgebildet sind und worin das Leadframe aus CuSn6, CuSn8 oder aus FeNi42Cr5 besteht.

## Claims

1. Data medium in card form, which substantially consists of plastic, having at least one semiconductor memory element (4) with a storage capacity of at least one Mbit and having electroplated contacts (2) for the transmission of data between a data-processing system and the semiconductor memory elements of the data medium, wherein the electrical conductor paths (3) on the data medium for the connection of the semiconductor memory elements to the electroplated contacts are represented by a single leadframe on which at least parts of the electroplated contacts are integrally formed, and wherein the leadframe consists of CuSn6, CuSn8 or of FeNi42Cr5.

## Revendications

1. Support de données sous forme de carte qui est principalement fabriqué en matière plastique, qui comporte au moins un élément de mémoire semiconducteur (4) avec une capacité de mémoire d'au moins un Mbit et des contacts galvaniques (2) pour la transmission de données entre un système de traitement de données et les éléments de mémoire semi-conducteurs du support de données, dans lequel les circuits conducteurs électriques (3) sont représentés sur le support de données pour la liaison entre les éléments de mémoire semi-conducteurs et les contacts galvaniques par une seule grille de connexion sur laquelle au moins une partie des contacts galvaniques est réalisée intégralement et dans lequel la grille de connexion est en CuSn6, CuSn8 ou en FeNi42Cr5.
